# FASCICULE DE BREVET EUROPEEN

(11) **EP 3 848 978 B1**
(45) Date de publication et mention de la délivrance du brevet: **30.04.2025**
(21) Numéro de dépôt: 21150641.5
(22) Date de dépôt: 08.01.2021
(51) Int. Cl.: H10D 8/20, H10D 8/01, H10D 64/00, H10D 89/60

(54) **PROTECTION ESD**
ESD-SCHUTZ
ESD PROTECTION

(30) Priorité: 09.01.2020 FR 2000159
(43) Date de publication de la demande: 14.07.2021
(73) Titulaire: STMicroelectronics (Tours) SAS, 37100 Tours (FR)
(72) Inventeur: ARNAUD, Aurelie, 37540 SAINT-CYR-SUR-LOIRE (FR); LEBRETTE, Severine, 37000 TOURS (FR)
(74) Mandataire: Cabinet Beaumont

(56) Documents cités:
- US-A1- 2015 137 305
- MATSUSHITA T ET AL: "HIGHLY RELIABLE HIGH-VOLTAGE TRANSISTORS BY USE OF THE SIPOS PROCESS", IEEE TRANSACTIONS ON ELECTRON DEVICES, IEEE SERVICE CENTER, PISACATAWAY, NJ, US, vol. ED23, no. 8, 1 August 1976 (1976-08-01), pages 826 - 830, XP000918483, ISSN: 0018-9383
- HIDENOBU MOCHIZUKI ET AL: "Semi-Insulating Polycrystalline-Silicon (SIPOS) Films Applied to MOS Integrated Circuits", JAPANESE J OF APPLIED PHYSICS.SUPP,, vol. 15, no. 7, 1 January 1976 (1976-01-01), pages 41, XP001288430
- HAMASAKI M ET AL: "Electronic properties of Semi-Insulating Polycrystalline-Silicon (SIPOS) doped with oxygen atoms", SOLID STATE COMMUNICATIONS, PERGAMON, GB, vol. 21, no. 6, 1 February 1977 (1977-02-01), pages 591 - 593, XP024479797, ISSN: 0038-1098, [retrieved on 19770201], DOI: 10.1016/0038-1098(77)90040-0
- LISS B ET AL: "Charging properties of SIPOS used as a passivation layer on silicon", SOLID STATE DEVICE RESEARCH CONFERENCE, 1991. ESSDERC '91. 21ST EUROPEAN, IEEE, PISCATAWAY, NJ, USA, 16 September 1991 (1991-09-16), pages 125 - 128, XP031650821, ISBN: 978-0-444-89066-5

## Description

### Domaine technique

La présente description concerne de façon générale les dispositifs électroniques et, plus particulièrement, les dispositifs électroniques de protection contre des décharges électrostatiques.

### Technique antérieure

On connaît différents dispositifs de prévention et de protection contre les décharges électrostatiques. Les documents US2015/137305, XP000918483 (article intitulé "Highly reliable high-voltage transistors by use of the SIPOS process" de Matsushita et al.), XP001288430 (article intitulé "Semi-Insulating Polycrystalline-Silicon (SIPOS) Films Applied to MOS Integrated Circuits" de Hidenobu Mochizuki et al.) et XP024479797 (article intitulé "Electronic properties of Semi-Insulating Polycrystalline-Silicon (SIPOS) doped with oxygen atoms" de Hamasaki et al.), décrivent des exemples de dispositifs électroniques et de procédés de fabrication de dispositifs électroniques. En particulier, le document US2015/137305 décrit un dispositif électronique selon le préambule de la revendication 1.

### Résumé de l'invention

Il existe un besoin d'améliorer les performances des dispositifs de protection contre des décharges électrostatiques actuels.

L'objectif ci-dessus est atteint au moyen d'un dispositif selon la revendication 1 et d'un procédé de fabrication dudit dispositif selon la revendication 7.

Selon un mode de réalisation, la troisième couche est en verre de silicate non dopé.

Selon un mode de réalisation, la troisième couche est en orthosilicate de tétraéthyle.

Selon un mode de réalisation, la troisième couche a une épaisseur comprise entre 1 µm et 4 µm, de préférence égale à environ 2 µm, plus préférentiellement égale à 2 µm.

Selon un mode de réalisation, la deuxième couche a une épaisseur comprise entre 0,3 µm et 1 µm, de préférence égale à environ 0,8 µm, plus préférentiellement égale à 0,8 µm.

Selon un mode de réalisation, la première couche a une épaisseur comprise entre 8 µm et 15 µm, de préférence égale à environ 12 µm, plus préférentiellement égale à 12 µm.

Selon un mode de réalisation, la deuxième couche est déposée par dépôt chimique en phase vapeur à pression sous-atmosphérique.

Selon un mode de réalisation, la troisième couche est déposée par dépôt chimique en phase vapeur assisté par plasma.

Selon un mode de réalisation, la deuxième couche et la troisième couche sont gravées simultanément à l'aplomb de la deuxième zone.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un dispositif de protection contre des décharges électrostatiques ;
la figure 2 représente une étape d'un mode de mise en oeuvre d'un procédé de fabrication du dispositif de la figure 1 ;
la figure 3 représente une autre étape d'un mode de mise en oeuvre d'un procédé de fabrication du dispositif de la figure 1 ;
la figure 4 représente une autre étape d'un mode de mise en oeuvre d'un procédé de fabrication du dispositif de la figure 1 ;
7la figure 5 représente une autre étape d'un mode de mise en oeuvre d'un procédé de fabrication du dispositif de la figure 1 ;
la figure 6 représente une autre étape d'un mode de mise en oeuvre d'un procédé de fabrication du dispositif de la figure 1 ;
la figure 7 représente une autre étape d'un mode de mise en oeuvre d'un procédé de fabrication du dispositif de la figure 1 ;
la figure 8 représente une autre étape d'un mode de mise en oeuvre d'un procédé de fabrication du dispositif de la figure 1 ;
la figure 9 représente une autre étape d'un mode de mise en oeuvre d'un procédé de fabrication du dispositif de la figure 1 ; et
la figure 10 est une représentation graphique illustrant un exemple d'évolution de capacités parasites présentes dans le dispositif illustré en figure 1 ; et
la figure 11 est une représentation graphique illustrant un autre exemple d'évolution de capacités parasites présentes dans le dispositif illustré en figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, on prend pour exemple une application aux circuits de protection contre les décharges électrostatiques mais les modes de réalisation décrits de couche dopée en oxygène limitant un transfert de charges s'appliquent plus généralement à tous les circuits intégrés nécessitant une telle barrière aux transferts de charges.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

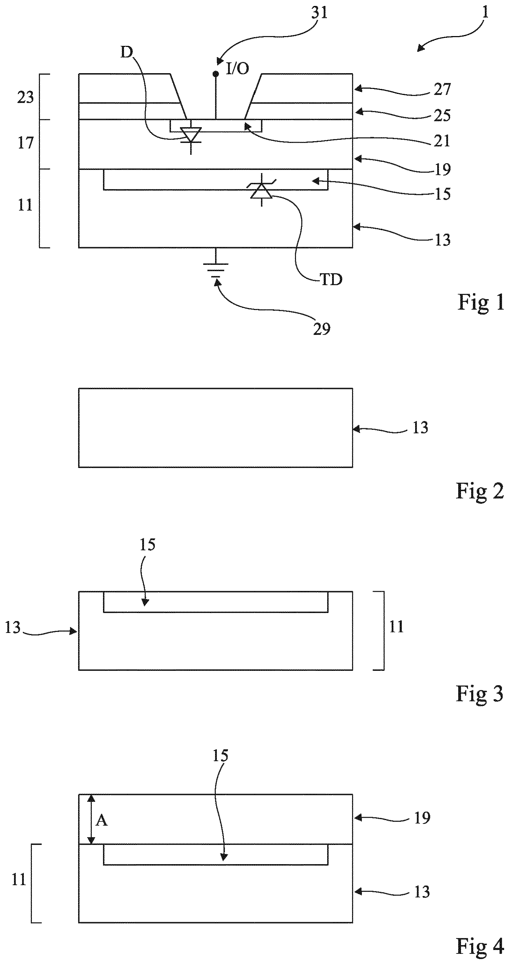

La figure 1 est une vue en coupe, partielle et schématique, d'un mode de réalisation d'un dispositif 1 de protection contre des décharges électrostatiques.

Plus particulièrement, la figure 1 représente un circuit de protection contre les décharges électrostatiques réalisé sous forme intégrée.

Dans la suite de la description, on considère la face supérieure de la structure ou d'une couche, dans l'orientation de la figure 1, comme étant la face avant et la face inférieure de la structure ou d'une couche, dans l'orientation de la figure 1, comme étant la face arrière.

Le dispositif 1 comprend :
un premier empilement 11 comportant un substrat 13 dans lequel est située une première zone 15 affleurant la face supérieure du substrat 13 ;
un deuxième empilement 17, situé sur et en contact avec la face supérieure du premier empilement 11, comportant une première couche 19 dans laquelle est située une deuxième zone 21 affleurant la face supérieure de la première couche 19 ; et
un troisième empilement 23, situé sur et en contact avec la face supérieure du deuxième empilement 17, comportant au moins une deuxième couche 25.

Le substrat 13 est en un matériau semiconducteur d'un premier type de conductivité, par exemple, fortement dopé. Le substrat 13 est par exemple en silicium.

La première zone 15 s'étend, par exemple, dans le plan de la face avant du substrat sur une surface inférieure à la surface du substrat 13. La première zone 15 est en un matériau d'un deuxième type de conductivité, différent du premier type de conductivité.

La première couche 19 est en un matériau du premier type de conductivité, par exemple, très faiblement dopé. Le matériau de la première couche 19 a, par exemple, une conductivité comprise entre 20 Ω.cm⁻¹ et 100 Ω.cm⁻¹.

La deuxième zone 21 est, par exemple, située en vis-à-vis de la première zone 15, en s'étendant, dans le plan de la face avant du substrat, sur une surface inférieure à la surface de la première zone 15. La deuxième zone 21 est en un matériau du deuxième type de conductivité, par exemple, fortement dopé.

La deuxième couche 25 est ouverte en vis-à-vis d'une partie de la deuxième zone 21. En d'autres termes, la couche 25 découvre une portion de la deuxième zone 21. La deuxième couche 25 est en un matériau dopé en oxygène ou SIPOS (Semi-Insulating POlycrystalline Silicon). Le SIPOS correspond à un silicium partiellement oxydé, c'est-à-dire un silicium qui possède, généralement, une concentration en oxygène supérieure à environ 10 %. La concentration en oxygène du SIPOS dans la présente description est, de préférence, comprise entre 20 % et 50 % et est, plus préférentiellement, comprise entre 25 % et 35%.

Le troisième empilement 23 du dispositif 1 illustré en figure 1 comprend, selon l'invention, une troisième couche 27 sur et en contact avec la face avant de la deuxième couche 25. La troisième couche 27 est un oxyde de champ, par exemple, un verre de silicate non dopé ou USG (Undoped Silicate Glass), ou de l'orthosilicate de tétraéthyle (TEOS). La troisième couche 27 est ouverte, en vis-à-vis de la deuxième zone 21, de sorte que l'ouverture de la deuxième couche 25 soit centrée (horizontalement dans l'orientation de la figure 1) avec l'ouverture de la troisième couche 27.

Le premier empilement 11 forme, par sa jonction entre la zone 15 et le substrat 13, une diode Zener, par exemple une diode connue sous la dénomination commerciale Transil, TD, dont la cathode est la première zone 15 et l'anode est le substrat 13.

Le deuxième empilement 17 forme, par sa jonction entre la couche 19 et la zone 21, une diode D dont la cathode est la première couche 19 et l'anode est la deuxième zone 21.

Le dispositif 1 est destiné à être relié à la masse 29 par la face arrière du substrat 13 et comprend un plot d'entrée/sortie 31 (I/O) relié, de préférence connecté, à la deuxième zone 21.

Un avantage du présent mode de réalisation est l'isolation apportée par la deuxième couche 25 en silicium dopé en oxygène. En effet, la deuxième couche 25 permet de limiter la transmission des charges positives de la troisième couche 27 d'oxyde de champ à la première couche 19. La migration des charges entre la troisième couche 27 et la couche 19 est diminuée car la nature (semi-isolante) de la deuxième couche 25 permet d'éviter l'accumulation de charges à l'interface avec la première couche 19.

Un autre avantage du présent mode de réalisation est de pouvoir augmenter l'épaisseur de la troisième couche 27 et ainsi diminuer la capacité globale en réduisant les capacités parasites de métallisation. Sans la couche 25, toute augmentation de la couche 27 pour réduire les capacités parasites aurait pour effet indésirable de modifier le dopage de la couche sous-jacente 19.

Les figures 2 à 9 illustrent, de façon schématique et partielle, des étapes successives d'un mode de mise en oeuvre d'un procédé de fabrication du dispositif 1 illustré en figure 1.

Pour simplifier la description, sauf précision contraire, on assimile une étape de fabrication à la structure obtenue à l'issue de cette étape.

La figure 2 représente une étape d'un mode de mise en oeuvre d'un procédé de fabrication du dispositif de la figure 1.

Plus particulièrement, la figure 2 représente une structure de départ composée du substrat 13.

La figure 3 représente une autre étape d'un mode de mise en oeuvre d'un procédé de fabrication du dispositif de la figure 1.

Plus particulièrement, la figure 3 illustre une étape de formation de la première zone 15 dans le substrat 13.

La première zone 15 est formée dans le substrat 13 de façon à ce que sa face avant affleure la face avant du substrat 13. La première zone 15 s'étend par exemple, dans le plan de la face avant du substrat, sur une surface inférieure à la surface du substrat 13.

A la fin de l'étape illustrée en figure 3, la première zone 15 est enterrée dans le substrat 13 et forme avec le substrat 13 le premier empilement 11.

La figure 4 représente une autre étape d'un mode de mise en oeuvre d'un procédé de fabrication du dispositif de la figure 1.

Plus particulièrement, la figure 4 illustre une étape de formation de la première couche 19 sur la face avant de la structure obtenue à l'issue des étapes des figures 2 et 3.

La couche 19 est formée sur l'ensemble de la structure (pleine plaque), c'est-à-dire qu'elle est formée sur la face supérieure du substrat 13 et de la première zone 15. La couche 19 a une épaisseur A sensiblement constante sur l'ensemble de sa surface.

L'épaisseur A de la première couche 19 est comprise entre 8 µm et 15 µm, de préférence égale à environ 12 µm. L'épaisseur A est plus préférentiellement égale à 12 µm.

La première couche 19 est formée, par exemple, par épitaxie à la surface du premier empilement 11.

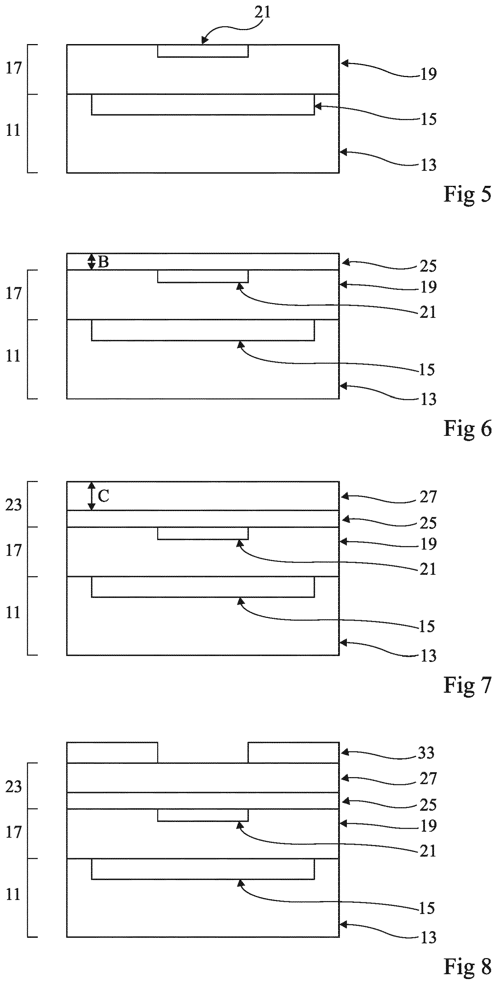

La figure 5 représente une autre étape d'un mode de mise en oeuvre d'un procédé de fabrication du dispositif de la figure 1.

Plus particulièrement, la figure 5 illustre une étape de formation de la deuxième zone 21 dans la première couche 19 de la structure obtenue à l'issue des étapes des figures2 à 4.

La deuxième zone 21 est formée dans la première couche 19 de façon à ce que la face avant de la deuxième zone 21 affleure la face avant de la couche 19. La deuxième zone 21 est, par exemple, située en vis-à-vis de la première zone 15 et centrée par rapport à celle-ci. La deuxième zone 21 s'étend, dans le plan de la face avant du substrat 13, sur une surface inférieure à la surface de la première zone 15.

A la fin de l'étape illustrée en figure 5, la deuxième zone 21 est enterrée dans la couche 19 et forme avec la couche 19 le deuxième empilement 17.

La figure 6 représente une autre étape d'un mode de mise en oeuvre d'un procédé de fabrication du dispositif de la figure 1.

Plus particulièrement, la figure 6 illustre une étape de dépôt de la deuxième couche 25 sur la face avant de la structure obtenue à l'issue des étapes des figures 2 à 5.

La couche 25 est déposée pleine plaque sur l'ensemble de la structure, c'est-à-dire qu'elle est déposée sur la face supérieure de la première couche 19 et sur la face avant de la deuxième zone 21. La couche 25 a une épaisseur B sensiblement constante sur l'ensemble de sa surface.

L'épaisseur B de la deuxième couche 25 est comprise entre 0,3 µm et 1 µm, de préférence égale à environ 0,8 µm. L'épaisseur B est plus préférentiellement égale à 0,8 µm.

La couche 25 est, par exemple, formée par un procédé de dépôt chimique en phase vapeur à pression sous atmosphérique (LPCVD, Low Pressure Chemical Vapor Deposition).

La figure 7 représente une autre étape d'un mode de mise en oeuvre d'un procédé de fabrication du dispositif de la figure 1.

Plus particulièrement, la figure 7 illustre une étape de dépôt de la troisième couche 27 sur la face avant de la structure obtenue à l'issue des étapes des figures 2 à 6.

La couche 27 est déposée pleine plaque sur l'ensemble de la structure, c'est-à-dire qu'elle est déposée sur la face supérieure de la couche 25. La couche 27 a une épaisseur C sensiblement constante sur l'ensemble de sa surface.

L'épaisseur C de la troisième couche 27 est comprise entre 1 µm et 4 µm, de préférence égale à environ 2 µm. L'épaisseur C est plus préférentiellement égale à 2 µm.

Selon un mode de réalisation, la troisième couche 27 est en USG (Undoped Silicate Glass) et est formée par dépôt chimique en phase vapeur assisté par plasma (PECVD, Plasma-Enhanced Chemical Vapor Deposition) . Ce dépôt est, par exemple, suivi d'un recuit de l'USG à une température de l'ordre d'environ 900 degrés Celsius.

Selon un autre mode de réalisation, la troisième couche 27 est du TEOS (orthosilicate de tétraéthyle) et est formée par LPCVD. Ce dépôt est, par exemple, suivi d'un recuit du TEOS à une température de l'ordre d'environ 900 degrés Celsius. Le dépôt de la couche 27 permet d'obtenir l'empilement 23.

La figure 8 représente une autre étape d'un mode de mise en oeuvre d'un procédé de fabrication du dispositif de la figure 1.

Plus particulièrement, la figure 8 illustre une étape de dépôt et de photolithographie d'une quatrième couche 33 d'une résine sur la face avant de la structure obtenue à l'issue des étapes des figures 2 à 7.

Dans le présent mode de réalisation, on vient recouvrir la troisième couche 27 par la quatrième couche 33. La quatrième couche 33 est déposée, par exemple, par centrifugation (spin-coating) de sorte à recouvrir la troisième couche 27.

La couche 33 subit, ensuite, une photolithographie, c'est-à-dire que la couche 33 est exposée aux UV au travers d'un masque puis elle est développée dans un solvant.

La résine est, par exemple, une résine positive, c'est-à-dire que la partie de la résine exposée aux UV devient soluble dans un solvant.

La couche 33 s'étend, à l'issue de l'étape de photolithographie, sur l'ensemble de la couche 27 et sur une partie de la deuxième zone 21 en laissant une portion de la zone 21 non recouverte par la couche 33.

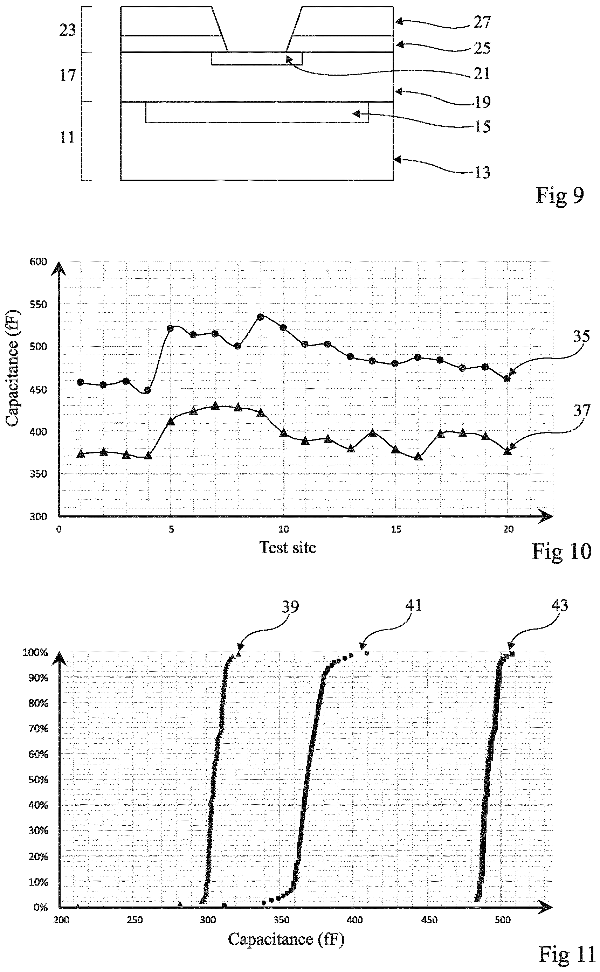

La figure 9 représente une autre étape d'un mode de mise en oeuvre d'un procédé de fabrication du dispositif de la figure 1.

Plus particulièrement, la figure 9 illustre une étape de gravure de la deuxième couche 25 et de la troisième couche 27 à partir de la structure obtenue à l'issue des étapes des figures 2 à 8.

On vient retirer par gravure les parties des couches 25 et 27 qui ne sont pas surmontées par la couche 33.

La gravure des couches 25 et 27 permet de former une ouverture, traversante, dans ces deux couches 25 et 27 et ainsi découvrir une portion de la deuxième zone 21.

Selon le mode de réalisation illustré en figure 9, la gravure est effectuée de sorte que les flancs de l'ouverture soient obliques et que l'ouverture se rétrécisse avec sa profondeur. En d'autres termes, à l'issue de l'étape illustrée en figure 9, l'ouverture est plus étroite au niveau de la face avant de la zone 21 qu'au niveau de la face avant de la couche 27.

Lors de cette étape, la couche 33 est éliminée. A l'issue de l'étape illustrée en figure 9, la structure ne comprend donc plus de couche 33.

La figure 10 est une représentation graphique illustrant un exemple d'évolution de capacités parasites présentes dans le dispositif illustré en figure 1.

Plus particulièrement, la figure 10 illustre l'évolution des capacités parasites (capacitance) en femtoFarad (fF) en fonction des sites de mesure (test site) et de la composition de l'empilement 23. Les mesures ont été réalisées sur vingt sites de mesure différents, c'est-à-dire que les mesures ont été réalisées sur vingt dispositifs (1, figure 1) différents.

Le graphique de la figure 10 comprend deux courbes :
une première courbe 35 représentant l'évolution des capacités parasites, l'empilement 23 étant composé d'une unique couche en TEOS ; et
une deuxième courbe 37 représentant l'évolution des capacités parasites, l'empilement 23 étant composé d'une couche de SIPOS et d'une couche d'USG.

Ces allures montrent que la présence de la couche en SIPOS dans l'empilement 23 permet de diminuer les capacités parasites de l'ordre de 20 % par rapport au cas où il n'y a pas de couche de SIPOS dans l'empilement 23. En présence d'une unique couche de TEOS, sans SIPOS, les capacités parasites sont mesurées entre 440 fF et 540 fF selon les sites de mesure avec une moyenne de 486 fF. En présence d'une couche 25 de SIPOS et d'une couche d'oxyde de champ USG, les capacités parasites sont mesurées entre 360 fF et 430 fF selon les sites de mesure avec une moyenne de 394 fF.

La figure 11 est une représentation graphique illustrant un autre exemple d'évolution de capacités parasites présentes dans le dispositif illustré en figure 1.

Plus particulièrement, la figure 11 illustre l'évolution de la distribution des capacités parasites (capacitance) en femtoFarad (fF) en fonction de la composition de l'empilement 23.

Le graphique de la figure 11 comprend trois courbes :
une troisième courbe 39 représentant l'évolution des capacités parasites, l'empilement 23 étant composé d'une couche de SIPOS surmontée d'une couche de USG ;
une quatrième courbe 41 représentant l'évolution des capacités parasites, l'empilement 23 étant composé d'une couche de SIPOS et d'une couche de TEOS ; et
une cinquième courbe 43 représentant l'évolution des capacités parasites, l'empilement 23 étant composé d'une couche d'un oxyde thermique sans SIPOS et d'une couche de TEOS.

Ces courbes 39, 41 et 43 montrent que les capacités parasites du dispositif sont plus faibles lorsque l'empilement 23 comprend une couche de SIPOS. Les capacités parasites sont, en outre, plus faibles lorsque la couche de SIPOS est recouverte d'une couche de USG par rapport à une couche de TEOS.

Un avantage des modes de réalisation décrits est qu'ils permettent d'augmenter l'épaisseur d'oxyde de champ sans modifier le dopage de la couche épitaxiée sous-jacente 19.

Un autre avantage des modes de réalisation décrits est qu'ils permettent de diminuer les capacités parasites de métallisation, de réduire la capacité de ligne et ainsi limiter la perte des données lorsque le dispositif est utilisé dans un ordinateur ou tout autre produit électronique.

Divers modes de réalisation et variantes ont été décrits. La personne du métier comprendra que certaines caractéristiques de ces divers modes de réalisation et variantes pourraient être combinées, et d'autres variantes apparaitront à la personne du métier. Les modes de réalisations décrits ne se limitent pas aux exemples de dimensions et de matériaux mentionnées ci-dessus.

Enfin, la mise en oeuvre pratique des modes de réalisation et variantes décrits est à la portée de la personne du métier à partir des indications fonctionnelles données ci-dessus.

L'étendue de la protection couvre la portée des revendications.

## Revendications

1. Dispositif (1) de protection contre des décharges électrostatiques, comprenant :
un premier empilement (11), formant une diode Zener (TD), comportant un substrat (13) d'un premier type de conductivité dans lequel est située une première zone (15) d'un deuxième type de conductivité, la première zone (15) affleurant une face du substrat (13) ;
un deuxième empilement (17), formant une diode (D), situé sur et en contact avec ladite face du substrat (13) et comportant une première couche (19) du deuxième type de conductivité dans laquelle est située une deuxième zone (21) du premier type de conductivité, la deuxième zone (21) affleurant, à l'opposé du premier empilement (11), la surface de la première couche (19) ; et
un troisième empilement (23) comportant au moins une deuxième couche (25) en un silicium polycristallin dopé en oxygène, sur et en contact avec le deuxième empilement (17),
dans lequel le troisième empilement (23) comporte une troisième couche (27) d'un oxyde de champ sur et en contact avec la deuxième couche (25).

2. Dispositif selon la revendication 1, dans lequel la troisième couche (27) est en verre de silicate non dopé.

3. Dispositif selon la revendication 1, dans lequel la troisième couche (27) est en orthosilicate de tétraéthyle.

4. Dispositif selon l'une quelconque des revendications 1 à 3, dans lequel la troisième couche (27) a une épaisseur comprise entre 1 µm et 4 µm, de préférence égale à environ 2 µm, plus préférentiellement égale à 2 µm.

5. Dispositif selon l'une quelconque des revendications 1 à 4, dans lequel la deuxième couche (25) a une épaisseur comprise entre 0,3 µm et 1 µm, de préférence égale à environ 0,8 µm, plus préférentiellement égale à 0,8 µm.

6. Dispositif selon l'une quelconque des revendications 1 à 5, dans lequel la première couche (19) a une épaisseur comprise entre 8 µm et 15 µm, de préférence égale à environ 12 µm, plus préférentiellement égale à 12 µm.

7. Procédé de fabrication d'un dispositif (1) selon l'une quelconque des revendications 1 à 6, comportant, au moins, les étapes suivantes :
former la première zone (15) dans le substrat (13) ;
former la première couche (19) par épitaxie, sur et en contact avec ladite face du substrat (13) et former la deuxième zone (21) dans la première couche (19) ; et
former la deuxième couche (25) sur et en contact avec le deuxième empilement (17).

8. Procédé selon la revendication 7, dans lequel la deuxième couche (25) est déposée par dépôt chimique en phase vapeur à pression sous-atmosphérique.

9. Procédé selon la revendication 7 ou 8, dans lequel la troisième couche (27) est déposée par dépôt chimique en phase vapeur assisté par plasma.

10. Procédé selon l'une quelconque des revendications 7 à 9, dans lequel la deuxième couche (25) et la troisième couche (27) sont gravées simultanément à l'aplomb de la deuxième zone (21).

## Patentansprüche

1. Schutzvorrichtung gegen elektrostatische Entladung (1), aufweisend:
einen ersten Stapel (11), der eine Zenerdiode (TD) bildet, aufweisend ein Substrat (13) eines ersten Leitfähigkeitstyps mit einem darin angeordneten ersten Bereich (15) eines zweiten Leitfähigkeitstyps, wobei der erste Bereich (15) bündig mit einer Oberfläche des Substrats (13) ist;
einen zweiten Stapel (17), der eine Diode (D) bildet, der sich auf der Oberfläche des Substrats (13) befindet und mit dieser in Kontakt steht und eine erste Schicht (19) des zweiten Leitfähigkeitstyps mit einem zweiten Bereich (21) des ersten Leitfähigkeitstyps darin aufweist, wobei der zweite Bereich (21) an der dem ersten Stapel (11) entgegengesetzten Seite bündig mit der Oberfläche der ersten Schicht (19); und
einen dritten Stapel (23), der mindestens eine zweite Schicht (25) aus sauerstoffdotiertem polykristallinem Silizium aufweist, die sich auf dem zweiten Stapel (17) befindet und mit diesem in Kontakt steht,
wobei der dritte Stapel (23) eine dritte Schicht (27) aus einem Feldoxid aufweist, die sich auf der zweiten Schicht (25) befindet und mit dieser in Kontakt steht.

2. Vorrichtung nach Anspruch 1, wobei die dritte Schicht (27) aus undotiertem Silikatglas besteht.

3. Vorrichtung nach Anspruch 1, wobei die dritte Schicht (27) aus Tetraethylorthosilikat besteht.

4. Vorrichtung nach einem der Ansprüche 1 bis 3, wobei die dritte Schicht (27) eine Dicke im Bereich von 1 µm bis 4 µm, vorzugsweise ungefähr 2 µm, stärker bevorzugt gleich 2 µm, aufweist.

5. Vorrichtung nach einem der Ansprüche 1 bis 4, wobei die zweite Schicht (25) eine Dicke im Bereich von 0,3 µm bis 1 µm, vorzugsweise ungefähr 0,8 µm, stärker bevorzugt gleich 0,8 µm, aufweist.

6. Vorrichtung nach einem der Ansprüche 1 bis 5, wobei die erste Schicht (19) eine Dicke im Bereich von 8 µm bis 15 µm, vorzugsweise ungefähr 12 µm, stärker bevorzugt gleich 12 µm, aufweist.

7. Verfahren zur Herstellung der Vorrichtung (1) nach einem der Ansprüche 1 bis 6, dass mindestens die folgenden Schritte aufweist:
Ausbilden des ersten Bereichs (15) in dem Substrat (13);
Ausbilden der ersten Schicht (19) durch Epitaxie auf und in Kontakt mit der Oberfläche des Substrats (13) und Ausbilden des zweiten Bereichs (21) in der ersten Schicht (19); und
Ausbilden der zweiten Schicht (25) auf und in Kontakt mit dem zweiten Stapel (17).

8. Verfahren nach Anspruch 7, wobei die zweite Schicht (25) durch Niederdruck-Chemische-Gasphasenabscheidung abgeschieden wird.

9. Verfahren nach Anspruch 7 oder 8, wobei die dritte Schicht (27) durch plasmaunterstützte Chemische-Gasphasenabscheidung abgeschieden wird.

10. Verfahren nach einem der Ansprüche 7 bis 9, wobei die zweite Schicht (25) und die dritte Schicht (27) gleichzeitig vertikal in einer Linie mit dem zweiten Bereich (21) geätzt werden.

## Claims

1. Electrostatic discharge protection device (1) comprising:
a first stack (11), forming a Zener diode (TD), comprising a substrate (13) of a first conductivity type having a first area (15) of a second conductivity type located therein, the first area (15) being flush with a surface of the substrate (13);
a second stack (17), forming a diode (D), located on top of and in contact with said surface of the substrate (13) and comprising a first layer (19) of the second conductivity type having a second area (21) of the first conductivity type located therein, the second area (21) being flush, opposite the first stack (11), with the surface of the first layer (19); and
a third stack (23) comprising at least a second layer (25) made of oxygen-doped polycrystalline silicon, on top of and in contact with the second stack (17),
wherein the third stack (23) comprises a third layer (27) of a field oxide on top of and in contact with the second layer (25).

2. The device of claim 1, wherein the third layer (27) is made of undoped silicate glass.

3. The device of claim 1, wherein the third layer (27) is made of tetraethyl orthosilicate.

4. The device of any of claims 1 to 3, wherein the third layer (27) has a thickness in the range from 1 µm to 4 µm, preferably equal to approximately 2 µm, more preferably equal to 2 µm.

5. The device of any of claims 1 to 4, wherein the second layer (25) has a thickness in the range from 0.3 µm to 1 µm, preferably equal to approximately 0.8 µm, more preferably equal to 0.8 µm.

6. The device of any of claims 1 to 5, wherein the first layer (19) has a thickness in the range from 8 µm to 15 µm, preferably equal to approximately 12 µm, more preferably equal to 12 µm.

7. A method of manufacturing the device (1) of any of claims 1 to 6, comprising at least the steps of:
forming the first area (15) in the substrate (13);
forming the first layer (19) by epitaxy, on top of and in contact with said surface of the substrate (13) and forming the second area (21) in the first layer (19); and
forming the second layer (25) on top of and in contact with the second stack (17).

8. The method of claim 7, wherein the second layer (25) is deposited by low pressure chemical vapor deposition.

9. The method of claim 7 or 8, wherein the third layer (27) is deposited by plasma-enhanced chemical vapor deposition.

10. The method of any of claims 7 to 9, wherein the second layer (25) and the third layer (27) are simultaneously etched vertically in line with the second area (21).
